# EUROPEAN PATENT APPLICATION

(11) **EP 4 311 866 A1**
(43) Date of publication of application: **31.01.2024**
(21) Application number: 23188265.5
(22) Date of filing: 27.07.2023
(51) Int. Cl.: C23C 16/448, C23C 16/455, C23C 16/52

(54) **SEMICONDUCTOR MANUFACTURING MONITORING PROCESS**

(30) Priority: 28.07.2022 US 202263369698 P
(71) Applicant: ASM IP Holding B.V., 1322 AP Almere (NL)
(72) Inventor: Deckers, Jan, 1322 AP Almere (NL); Shero, Eric James, 1322 AP Almere (NL)
(74) Representative: V.O.

(57) **Abstract**

The invention provides in method and systems for determining the amount of solid precursor in a precursor vessel of a semiconductor manufacturing process, wherein the amount of precursor in the precursor vessel is determined by measuring through monochromatic measurements an optical absorption in the process gas flowing from the precursor vessel to the process chamber.

## Description

### FIELD

In general the various aspect of the technology of the present disclosure generally relate to semiconductor processing, and particularly to monitoring the amount of solid precursor in a precursor vessel for a semiconductor manufacturing process.

### BACKGROUND

With semiconductors and semiconductor manufacturing processes becoming more advanced, there is a need for greater uniformity and process control during the manufacturing process.

During processes such as Atomic Layer Deposition (ALD), Epitaxy and Chemical Vapor Deposition (CVD) precursors which may be in the form of a gas, liquid or solid are deposited onto or contacted with a workpiece. These precursors are often stored in precursor container or precursor vessel from where they are transported to the workpiece in the reaction chamber.

While the process is being performed, it may be advantageous to monitor the amount of precursor in the precursor vessel in order to prevent manufacturing defects due to exhaustion of the precursor material. The ability to monitor remaining amount of precursor material in the precursor vessel is important because it ensures process quality, allows efficient scheduling of precursor vessel changes, maximizes use of expensive chemistry, and improves inventory management.

Whereas level sensing is industry standard for gaseous or liquid materials, monitoring the remaining amount of a solid precursor material is more complex. Typically, the precursor material is transported from the precursor vessel to the process chamber by flowing a carrier gas through the precursor vessel, thereby generating a process gas comprising the carrier gas and vaporized solid precursor which is subsequently provided to the process chamber. Several of the process conditions employed to the manufacturing process (e.g. high temperature range, the use of carrier gas...) result in the monitoring of the precursor level becoming challenging for existing Level Sensing systems especially when resolution and accuracy are key.

Therefore, a need exists for an improved method and apparatus for monitoring the amount of solid precursor in a precursor vessel for a semiconductor manufacturing process.

### SUMMARY

A first overview of various aspects of the technology of the present disclosure is given hereinbelow, after which specific embodiments will be described in more detail. This overview is meant to aid the reader in understanding the technological concepts more quickly, but it is not meant to identify the most important or essential features thereof, nor is it meant to limit the scope of the present disclosure, which is limited only by the claims.

An aspect of the present disclosure relates to a method for determining the amount of solid precursor in a precursor vessel for a semiconductor manufacturing process, wherein said solid precursor is provided from said precursor vessel to a process chamber by:
- flowing a carrier gas through said precursor vessel, thereby generating a process gas comprising said carrier gas and vaporized solid precursor, and
- providing said process gas to said process chamber where said precursor is reacted with a substrate,
the method comprising the step of:
- measuring an amount of optical absorption of that process gas through monochromatic measurements in said process gas, and
- determining, based on the measurement of said amount of optical absorption of that process gas, said amount of precursor in said precursor vessel.

More in particular, the method as disclosed herein provides that the measurement of said amount of optical absorption of that process gas is an in-line measurement in the gas line fluidically connecting said precursor vessel to said process chamber.

More in particular, the method according to the present disclosure provides that said amount of optical absorption of that process gas comprises a quasi-steady-state measurement.

More in particular, the method as disclosed herein provides that said measurement of said amount of optical absorption of that process gas comprises a transient measurement.

More in particular, the method according to the present disclosure provides that said method further comprises the step of determining, based on said measurement of said amount of optical absorption of that process gas, the time remaining before said precursor vessel is depleted and/or requires refilling.

More in particular, the method as disclosed herein provides that determining the amount of precursor in said precursor vessel comprises determining, based on said measurement of said amount of optical absorption of that process gas, the remaining amount of precursor in said precursor vessel.

More in particular, the method according to the present disclosure provides that said method further comprises the step of determining, based on said measurement of said amount of optical absorption of that process gas, the amount of precursor delivered to said process chamber.

More in particular, the method as disclosed herein provides that said method further comprises the step of regulating, on the basis of said measurement of said amount of optical absorption of that process gas, the delivery of said precursor to said process chamber by adjusting the volume flow rate of said carrier gas.

More in particular, the method according to the present disclosure provides that said precursor comprises a metal. More particularly, said metal is selected from an alkaline metal, an alkaline earth metal, a transition metal, a transition metal, a rare earth metal or a combination thereof.

More in particular, the method as disclosed herein provides that the precursor comprises one or more ligands, the one or more ligands being selected from H, halogens, alkyls, alkenyls, alkynes, carbonyls, dienyls, beta-diketonates, substituted or unsubstituted cyclodienyls, substituted or unsubstituted aryls or a combination thereof.

More in particular, the method according to the present disclosure provides that the precursor is homoleptic or heteroleptic.

More in particular, the method as disclosed herein provides that the precursor comprises a metal-carbon bond.

More in particular, the method according to the present disclosure provides that the precursor comprises a metal-pi complex.

Another aspect of the present disclosure relates to a system for the manufacturing of semiconductors comprising at least a precursor vessel, a process chamber and a gas line between said precursor vessel and said process chamber, wherein said system further comprises a single-wavelength absorption-based detection system positioned on said gas line, adapted for measuring the amount of optical absorption of that process gas in the process gas passing through said gas line, said system further comprising a controller communicatively coupled to said detection system and configured to determine the amount of solid precursor in said precursor vessel from the measurements of said detection system.

More in particular, the system as disclosed herein provides that said detection system comprises at least a monochromatic light source and a detector adapted for measuring the absorption of monochromatic light in said gas line.

More in particular, the system according to the present disclosure provides that said system further comprises a flow meter for determining the volume flow rate of said process gas through said gas line.

More in particular, the system as disclosed herein provides that said controller is further configured to determine the time remaining before the precursor vessel is depleted and/or requires refilling.

More in particular, the system according to the present disclosure provides that said controller is further configured to determine the amount of precursor delivered to said process chamber.

More in particular, the system as disclosed herein provides that said controller is configured to communicate the amount of precursor remaining in said precursor vessel and/or the mass flow rate of said precursor to said process chamber to a further system controller.

More in particular, the system according to the present disclosure provides that said controller or said system controller is configured to display the amount of precursor remaining in said precursor vessel and/or the mass flow rate of said precursor to said process chamber on a graphical user interface (GUI), wherein said controller or said system controller is further configured to generate an alarm message on said GUI in when said amount of precursor remaining in the vessel is below a pre-determined threshold value.

### BRIEF DESCRIPTION OF THE DRAWINGS

The following description of the figures relate to specific embodiments of the disclosure which are merely exemplary in nature and not intended to limit the present teachings, their application or uses.
Figure 1 schematically shows the amount of optical absorption of a process gas in function of time, the process gas flowing from the precursor vessel to the process chamber.
Figure 2 schematically shows an embodiment of a system according to the present disclosure.
Figure 3 schematically shows an embodiment of a system configuration for transient optical absorption measurements.
Figure 4 schematically shows an embodiment of a system configuration for quasi-steady-state optical absorption measurements.

### DETAILED DESCRIPTION

In the following detailed description, the technology underlying the present disclosure will be described by means of different aspects thereof. It will be readily understood that the aspects of the present disclosure, as generally described herein, and illustrated in the figures, can be arranged, substituted, combined, and designed in a wide variety of different configurations, all of which are explicitly contemplated and make part of this disclosure. This description is meant to aid the reader in understanding the technological concepts more easily, but it is not meant to limit the scope of the present disclosure, which is limited only by the claims.

Reference throughout this specification to "one embodiment" or "an embodiment" means that a particular feature, structure or characteristic described in connection with the embodiment is included in at least one embodiment of the present disclosure. Thus, appearances of the phrases "in one embodiment" or "in an embodiment" in various places throughout this specification are not necessarily all referring to the same embodiment.

As used herein, the terms "comprising", "comprises" and "comprised of" as used herein are synonymous with "including", "includes" or "containing", "contains", and are inclusive or open-ended and do not exclude additional, non-recited members, elements or method steps. The terms "comprising", "comprises" and "comprised of" when referring to recited members, elements or method steps also include embodiments which "consist of" said recited members, elements or method steps. The singular forms "a", "an", and "the" include both singular and plural referents unless the context clearly dictates otherwise.

As used herein, relative terms, such as "left," "right," "front," "back," "top," "bottom," "over," "under," etc., are used for descriptive purposes and not necessarily for describing permanent relative positions. It is to be understood that such terms are interchangeable under appropriate circumstances and that the embodiment as described herein are capable of operation in other orientations than those illustrated or described herein unless the context clearly dictates otherwise.

Objects described herein as being "adjacent" to each other reflect a functional relationship between the described objects, that is, the term indicates the described objects must be adjacent in a way to perform a designated function which may be a direct (*i.e*. physical) or indirect (*i.e*. close to or near) contact, as appropriate for the context in which the phrase is used.

Objects described herein as being "connected" or "coupled" reflect a functional relationship between the described objects, that is, the terms indicate the described objects must be connected in a way to perform a designated function which may be a direct or indirect connection in an electrical or nonelectrical (*i.e*. physical) manner, as appropriate for the context in which the term is used.

As used herein, the term "substantially" refers to the complete or nearly complete extent or degree of an action, characteristic, property, state, structure, item, or result. For example, an object that is "substantially" enclosed would mean that the object is either completely enclosed or nearly completely enclosed. The exact allowable degree of deviation from absolute completeness may in some cases depend on the specific context. However, generally speaking the nearness of completion will be so as to have the same overall result as if absolute and total completion were obtained. The use of "substantially" is equally applicable when used in a negative connotation to refer to the complete or near complete lack of an action, characteristic, property, state, structure, item, or result.

As used herein, the term "about" is used to provide flexibility to a numerical value or range endpoint by providing that a given value may be "a little above" or "a little below" said value or endpoint, depending on the specific context. Unless otherwise stated, use of the term "about" in accordance with a specific number or numerical range should also be understood to provide support for such numerical terms or range without the term "about". For example, the recitation of "about 30" should be construed as not only providing support for values a little above and a little below 30, but also for the actual numerical value of 30 as well.

The recitation of numerical ranges by endpoints includes all numbers and fractions subsumed within the respective ranges, as well as the recited endpoints. Furthermore, the terms first, second, third and the like in the description and in the claims, are used for distinguishing between similar elements and not necessarily for describing a sequential or chronological order, unless specified. It is to be understood that the terms so used are interchangeable under appropriate circumstances and that the embodiments of the disclosure described herein are capable of operation in other sequences than described or illustrated herein.

Reference in this specification may be made to devices, structures, systems, or methods that provide "improved" performance (e.g. increased or decreased results, depending on the context). It is to be understood that unless otherwise stated, such "improvement" is a measure of a benefit obtained based on a comparison to devices, structures, systems or methods in the prior art. Furthermore, it is to be understood that the degree of improved performance may vary between disclosed embodiments and that no equality or consistency in the amount, degree, or realization of improved performance is to be assumed as universally applicable.

In addition, embodiments of the present disclosure may include hardware, software, and electronic components or modules that, for purposes of discussion, may be illustrated and described as if the majority of the components were implemented solely in hardware. However, one of ordinary skill in the art, and based on a reading of this detailed description, would recognize that, in at least one embodiment, the electronic based aspects of the present disclosure may be implemented in software (e.g., instructions stored on non-transitory computer-readable medium) executable by one or more processing units, such as a microprocessor and/or application specific integrated circuits. As such, it should be noted that a plurality of hardware and software-based devices, as well as a plurality of different structural components may be utilized to implement the technology of the present disclosure. For example, "servers" and "computing devices" described in the specification can include one or more processing units, one or more computer-readable medium modules, one or more input/output interfaces, and various connections connecting the components.

An overview of various aspects of the technology of the present disclosure is given hereinbelow, after which specific embodiments will be described in more detail. This overview is meant to aid the reader in understanding the technological concepts more quickly, but it is not meant to identify the most important or essential features thereof, nor is it meant to limit the scope of the present disclosure, which is limited only by the claims. When describing specific embodiments, reference is made to the accompanying drawings, which are provided solely to aid in the understanding of the described embodiment.

Disclosed herein are methods and systems for determining the amount of solid precursor in a precursor vessel of a semiconductor manufacturing process, wherein the amount of precursor in the precursor vessel is determined by measuring through monochromatic measurements the amount of optical absorption of the process gas in the process gas flowing from the precursor vessel to the process chamber. This allows for a fast and accurate measurement of the amount of precursor remaining in the precursor vessel thereby allowing for vessel changes to be scheduled efficiently and improving the inventory management of the chemicals.

As referred to herein, the term "solid precursor" refers to the solid chemical compounds used in semiconductor manufacturing techniques such as Chemical Vapor Deposition (CVD) and Atomic Layer Deposition (ALD) to be deposited onto the surface of substrate in a thin layer or as an atomic layer. The precursor material may be chosen based on the particular process to be performed in the process chamber.

As referred to herein, the term "monochromatic measurements" refers to measurements using light centered at a single wavelength, as opposed to more expensive broad-spectrum techniques such as Fourier-Transform Infrared spectroscopy (FTIR). Monochromatic radiation can comprise light within a certain wavelength band with a gaussian intensity distribution around a central wavelength. In theory, monochromatic light has precisely only one wavelength, but in practice this is not possible, and therefore monochromatic light always consists of a (small) bandwidth of wavelengths. For example, a GaSb/AIGaSb multi-quantum well diode laser emits light in the infrared range at a wavelength of around 1550 nm. The actual intensity distribution depends on operating parameters and temperature of the light source. In particular embodiments the wavelength bandwidth is 100 nm or less, more in particular 50 nm or less. In particular embodiments the actual emission spectrum is confined in a 50 nm, 40 nm, 30 nm, 25 nm, 20 nm, 15 nm, 10 nm or 5 nm wavelength range.

As referred to herein, the term "process chamber" refers to the reaction chamber that is coupled to a solid delivery system. The process chamber may include an inner volume with a substrate support disposed therein for supporting a substrate to be processed (such as a semiconductor wafer or the like). The process chamber may be configured for ALD, CVD, or the like. The process chamber may further comprise a processing system comprising additional components, for example, one or more radio-frequency or other energy sources for generating a plasma within the inner volume or for providing radio-frequency bias to a substrate disposed on the substrate support.

An aspect of the present disclosure relates to a method for determining the amount of solid precursor in a precursor vessel for a semiconductor manufacturing process, wherein said solid precursor is provided from said precursor vessel to a process chamber by:
- flowing a carrier gas through said precursor vessel, thereby generating a process gas comprising said carrier gas and vaporized solid precursor, and
- providing said process gas to said process chamber where said precursor is reacted with a substrate,
the method comprising the step of:
- measuring the amount of optical absorption of the process gas through monochromatic measurements in said process gas, and
- determining, based on the measurement of said amount of optical absorption of the process gas, said amount of precursor in said precursor vessel.

As referred to herein, the term "precursor chamber" refers to the chamber that is coupled to the process chamber and comprises the solid precursor material. Some examples of precursor chambers as used herein are described in US20060216419. Some precursor chambers feature low profiles, in particular where the height of the chamber is smaller than the width or diameter of the chamber. In some embodiments, a low profile of the precursor chamber can provide that there is a high surface area for the precursor material, allowing the rapid evaporation of the precursor from the solid phase to the gas phase until it reaches its equilibrium vapor pressure in the precursor vessel. The low profile of the precursor chamber results in the measurement of the amount of precursor in the precursor vessel becoming more critical. Such measurements are in general more difficult for low profile vessels as compared to taller vessels with a relatively large initial fill level. Low profile precursor chambers as used herein exhibit non-uniform lateral consumption over the surface area and flow path direction, further complicating level sensing requirements. However, the methods and systems as disclosed herein allow for an efficient monitoring of the amount of precursor remaining in the precursor chamber, a method or system that is particularly suited for low profile vessels or chambers. The methods and systems as disclosed herein also allow the measurements to be done without being affected by the difficult sensing conditions in the precursor chamber due to the high temperatures (between 120°C and 200°C), the non-uniform lateral consumption over surface area and flow path direction and the presence of cold spots in the precursor chamber.

In particular, in the methods according to the present disclosure the precursor comprises a metal, more particularly, said metal is selected from an alkaline metal, an alkaline earth metal, a transition metal, a transition metal, a rare earth metal or a combination thereof. The precursor may also comprise one or more ligands, the one or more ligands being selected from H, halogens, alkyls, alkenyls, alkynes, carbonyls, dienyls, beta-diketonates, substituted or unsubstituted cyclodienyls, substituted or unsubstituted aryls or a combination thereof. Suitable halogens include F, Br, Cl, and/or I. Suitable alkyls, alkenyls, alkynes, dienyls, and cyclodienyls are typically C1 to C8 compounds. Suitable substituents on the cyclodienyls and aryls include C1 to C3 alkyls. Suitable beta-diketonates include 1,1,1,5,5,5-hexafluoropentane-2,4-dionate (hfac) and/or 2,4-pentanedione (hacac). In particular embodiments the precursor is a homoleptic chemical compound (a metal compound where all ligands are identical) or a heteroleptic chemical compound (a metal compound having two or more different types of ligand). In further particular embodiments the precursor comprises a metal-carbon bond. In further particular embodiments the precursor comprises a pi complex. An exemplary solid precursor is HfCl₄.

More in particular, the method as disclosed herein provides that the measurement of said amount of optical absorption of the process gas is an in-line measurement in the gas line fluidically connecting said precursor vessel to said process chamber.

More in particular, the method according to the present disclosure provides that said measurement of said amount of optical absorption of the process gas comprises a quasi-steady-state measurement or a transient measurement. By measuring the amount of optical absorption of the process gas the amount of precursor in the precursor vessel can be determined. The optical absorption of the process gas provides a concentration profile in the form of a pulse, and the characteristics of this pulse (e.g. width, shape, etc.) or series of pulses (e.g. time delay between the pulses) depends on the amount of precursor in the precursor vessel. The optical absorption of the process gas can be measured for any of the compounds present in the process gas, including the precursor, the carrier gas and/or another substance (e.g. He).

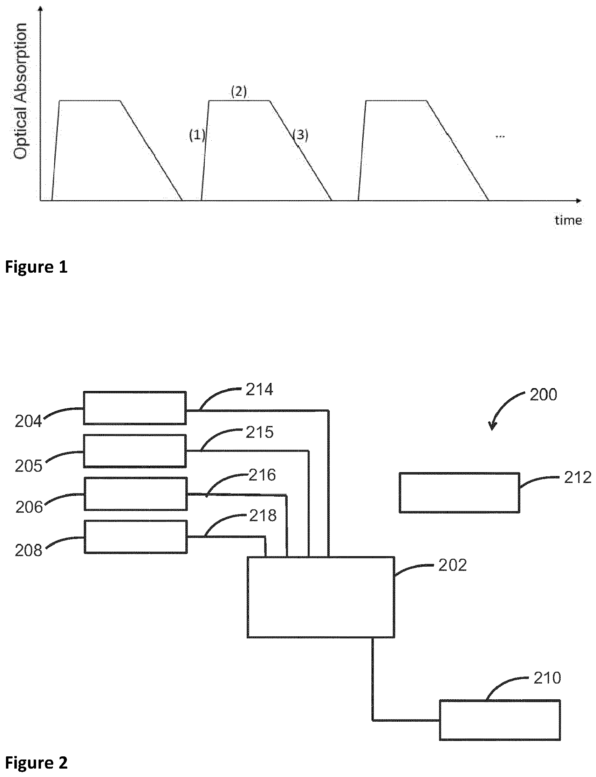

During the typical semiconductor manufacturing process the substrate undergoes a plurality of deposition cycles which typically comprise a precursor pulse and a reactant pulse. After a pre-determined amount of deposition cycles, the method ends. During such a precursor pulse solid precursor is transported from the precursor vessel to the process chamber by flowing a carrier gas through the precursor vessel, thereby generating a process gas comprising the carrier gas and vaporized solid precursor which is subsequently provided to the process chamber. As shown in figure 1, this typically occurs in a pulse train where at specified time intervals transport of the solid precursor from the precursor vessel to the process chamber occurs. After the pulse, carrier gas flow through the precursor vessel is halted for a pre-determined period of time, and the gas phase precursor concentration increases through evaporation. In some embodiments, the gas phase precursor concentration increases through evaporation until it reaches its equilibrium vapor pressure in the precursor vessel. Alternatively, the time between pulses can be shorter than the time required for the precursor partial pressure in the precursor vessel to reach its equilibrium vapor pressure. In such embodiments, the precursor partial pressure in the precursor vessel does not necessarily reach its equilibrium value before the next precursor pulse starts. A single precursor pulse can comprise three phases:
(1) an attack pulse phase corresponding to the start of carrier gas flowing through the precursor vessel;
(2) a sustain pulse phase corresponding to the point in time in which carrier gas flows in a steady state through the precursor vessel and entrains evaporated precursor; and;
(3) a release pulse phase corresponding to the point in time at which carrier gas has at least partially depleted the evaporated precursor from the precursor vessel.

Whereas in general the attack phase of the pulse can be very steep and instantaneous, it is generally not expected to contain any information on the amount of precursor remaining in the precursor vessel. The sustain phase of a pulse is ideally constant and stable. The height of the sustain phase of the precursor pulse is determined by the precursor's vapor pressure, which in turn is determined by the type of precursor used, and the temperature at which the precursor vessel is maintained. The length of the sustain phase of the pulse may contain information on the amount of precursor remaining in the precursor vessel. The release phase of the precursor pulse provides in a steady decrease of the precursor concentration in time. The steepness of this decrease corresponds to a decrease in optical absorption that may contain information on the amount of precursor remaining in the precursor vessel.

In some embodiments, determining a precursor fill level can comprise a measurement of the length of the sustain phase of the precursor pulse.

More in particular, the method according to the present disclosure provides that said measurement of said amount of optical absorption of the process gas comprises a quasi-steady-state measurement. Quasi steady-state measurements can provide an average amount of optical absorption of the process gas measured over a plurality of pulses, for example over from at least 1000 pulses to at most 1000 000 pulses. Quasi-steady-state measurements allow for slower and more sensitive sensors to be used to measure a time-averaged concentration of the precursor, which can be correlated with the amount of precursor remaining in the precursor vessel. Suitable sensors for quasi-steady-state measurements include fused silica fiber optic sensors, fused silica doped with cations, chalcogenide glasses, glasses comprising heavy halides such as iodine, and hollow-core fibers. Suitable hollow-core fibers can comprise a cladding made of metal or dielectric that has an anomalous dispersion with a refractive index smaller than one at the wavelength of operation. Further possible fiber optic sensors for use in quasi steady state operation include Bragg sensors, other optical sensors, Impedance sensors, thin-film transistor gas sensors, gas sensors based on surface plasmon resonance, pressure, sensors comprising a tapered fiber coated with metal, micromirror gas sensors, random hole optical fiber gas sensors, air-guiding photonic bandgap fibers, and photonic crystal fibers with side openings. It shall be understood that such sensors are, as such, known in the art. Suitable light sources for quasi steady state measurements include light emitting diodes (LEDs) such as LEDs emitting light in the ultraviolet range, the visible range, or the infrared range.

In particular embodiments the said measurement of optical absorption of the process gas is an in-line measurement in the gas line fluidically connecting said precursor vessel to said process chamber wherein the temperature in the gas line is higher than the temperature of the precursor source, and lower than the temperature of the reaction chamber. Accordingly, in a particular embodiment the measurement of said amount of optical absorption of the process gas comprises quasi steady state measurements in which the sensor and optionally also the light source and photodetector, are positioned in a high-temperature area, preferably at a temperature above 200 °C. In a particular embodiment the quasi steady state measurement system comprises a Bragg element positioned in the gas line, and a light source and a light detector positioned outside the gas line (preferably in low temperature environment preferably at a temperature below 90°C), the light source and a light detector being connected to the Bragg element through fiber optics, in particular fiber optics comprising one or more beam splitters. In a particular embodiment the Bragg element is a fiber optic cable with multiple regularly spaced notches. This quasi steady state measurement system allows for the sensing of the precursor concentration in the gas line. The precursor or analyte present in the process gas changes the refractive index and extinction coefficient of the gas phase, including in notches of the Bragg element. Accordingly, changes in the process gas changes the amount of reflected light by the Bragg reflector and this is indicative for the concentration of the precursor or analyte in the process gas. While this type of detection system is considered to have a relatively slow response, it is possible to measure the averaged precursor concentration over numerous pulses using this quasi steady state measurement system.

In particular embodiments the length of the sustain phase of the precursor pulse determines amount of precursor in said precursor vessel. A short length of the sustain phase means that there is a small free volume in the precursor vessel, and consequently the precursor vessel contains a high amount of solid precursor. Longer lengths of the sustain phase are caused by a larger free volume in precursor vessel and consequently lower amounts of solid precursor remaining in precursor vessel. Consequently, from the length of the sustain pulse phase the amount of solid precursor in said precursor vessel can be determined. In particular there is a linear correlation between the length of the sustain pulse phase and the amount of solid precursor in the precursor vessel.

More in particular, the method as disclosed herein provides that said measurement of said amount of optical absorption of the process gas comprises a transient measurement. As referred to herein a transient measurement refers to derivation of the amount of precursor comprised in the precursor source from a measurement of a change in amount of optical absorption of the process gas. It shall be understood that a transient measurement occurs in the timescale of a single pulse. The timescale of a single pulse can be in the order of microseconds to seconds, for example in the order of milliseconds to tens of milliseconds or hundreds of milliseconds. A transient measurement can refer in particular to a measurement of the steepness of the release phase of the precursor pulse. Transient measurements such as measurements of the steepness of the release phase of the precursor pulse require faster sensors with fast response times (i.e. response times that are shorter than the decay time of the precursor pulse time, e.g. in the order of milliseconds) to be used in the measurements.

Suitable sensors for transient measurements can include a plurality of mirrors, which can suitably be employed to increase the path length of light in the gas phase between a light source and a light detector.

Suitable light sources for transient measurements can include cooled lasers, e.g. operating at a temperature of at least 5 to at most 15°C, quantum cascade lasers, and interband cascade lasers.

Suitable photodetectors for transient measurements can infrared light detectors, ultraviolet light detectors, and visible light detectors.

In particular embodiments the said measurement of optical absorption of the process gas is an in-line measurement in the gas line fluidically connecting said precursor vessel to said process chamber wherein the temperature in the gas line is higher than the temperature of the precursor source, and lower than the temperature of the reaction chamber. Accordingly, in a particular embodiment the measurement of said amount of optical absorption of the process gas comprises transient measurements in which the light source and photodetector are positioned in a low temperature area (preferably at a temperature below 50°C), and light is brought to the gas line via fiber optics. The light travels freely through the gas line for a pre-determined distance. The precursor or analyte concentration in the gas line influences the optical absorption of the light passing through the gas line, hence allowing the measurement of the concentration of the precursor or analyte in the process gas. The temperature in the gas line can be, for example, from at least 100°C to at most 400°C.

In particular embodiments the steepness of the release phase of the precursor pulse determines amount of precursor in said precursor vessel. A fast release and thus a steep decrease of the release phase means that there is a small free volume in the precursor vessel, and consequently the precursor vessel contains a high amount of solid precursor. A slower release and therefore an unsteep release phase is caused by a larger free volume in precursor vessel and consequently lower amounts of solid precursor remaining in precursor vessel. Consequently, from the steepness of the release pulse phase the amount of solid precursor in said precursor vessel can be determined. In particular there can be a one-to-one relation, for example a linear correlation, between the steepness of the release pulse phase and the amount of solid precursor in the precursor vessel.

Accordingly, in particular embodiments the amount of precursor in said precursor vessel is determined by measuring the amount of optical absorption of the process gas of a precursor pulse and in particular by measuring the length of the sustain phase of the precursor pulse and/or the steepness of the release phase of the precursor pulse.

In yet another embodiment the height of the sustain phase of the precursor pulse may also provide an indication that the precursor vessel is nearly empty. A decrease in the height of the sustain pulse phase can be caused by not enough precursor being present in the precursor vessel to fully saturate the vapor phase. Because the amount of optical absorption of the process gas does not reach the vapor pressure the height of the sustain pulse phase decreases when compared to earlier precursor pulses.

It shall be understood that quasi-steady-state measurements can be conducted over a series of two or more precursor pulses, for example over from at least 100 to at most 100 000 precursor pulses. Such a measurement will give an optical absorption signal indicative of the average optical absorption value over the amount of pulses and in time the average optical absorption measured will become lower when insufficient precursor is provided from the precursor chamber. Thus, the average optical absorption measured can be correlated with the amount of precursor in the precursor vessel to determine the remaining amount of solid precursor in the precursor vessel.

The particular measurement methods as disclosed herein allow for an efficient measurement of the remaining amount of precursor in the precursor vessel. The sensing techniques as used herein are in particular suited to detect low amount of the precursor in the process gas. Typically the process gas comprises between 1.0% and 2.0% of precursor and between 98.0% and 99.0% of carrier gas.

Whereas in the measurements described here typically the concentration profile of a precursor in a pulse depends on the amount of precursor in the precursor vessel, it should be clear that the this can also be derived from the concentration profile of the carrier gas in a pulse or the concentration profile of another substance, called analyte, such as a noble gas such as He provided together with the carrier gas in a pulse. The difference between pulse width, pulse shape (e.g. tail steepness), or time delay between two or more pulses of precursor, carrier gas, and/or analyte concentration can depend on the amount of precursor in the precursor vessel. Accordingly, whereas the measurements described herein typically refer to the measurement of the amount of precursor in the process gas to determine the amount of precursor in the precursor vessel, this can also be done by measuring the carrier gas and/or analyte concentration.

More in particular, the method according to the present disclosure provides that said method further comprises the step of determining, based on said measurement of an optical absorption signal, the time remaining before said precursor vessel is depleted and/or requires refilling.

More in particular, the method as disclosed herein provides that determining the amount of precursor in said precursor vessel comprises determining, based on said measurement of the optical absorption signal, the remaining amount of precursor in said precursor vessel.

More in particular, the method according to the present disclosure provides that said method further comprises the step of determining, based on said measurement of the optical absorption signal, the amount of precursor delivered to said process chamber. The semiconductor manufacturing process occurring in the reaction chamber is typically a cyclical deposition process (such as atomic layer deposition) wherein a substrate is subjected to a number of deposition cycles. A deposition cycle typically comprises a precursor pulse and a reactant pulse which is repeated for a pre-determined amount of deposition cycles after which the method ends. During the precursor pulse the substrate is exposed to and reacts with the precursor. The precursor material may be chosen based on the particular process to be performed in the process chamber. During the reactant pulse the substrate is exposed to and reacts with the reactant. In particular embodiments the reactants include carbon reactants such as CH₄, nitrogen reactants such as NH₃, hydrogen reactants such as H₂, and oxygen reactants such as O₂.

Whereas the measurement of the absorption signal provides feedback to determine the amount of precursor remaining in the precursor vessel, this information can also be used to provide feedback to the process chamber. It may for instance be used to indicate that a correct amount of precursor was provided to the process chamber, allowing for early error detection. This information on the amount of precursor delivered to the process chamber further allows to make a post-assessment of the quality of the semiconductor manufacturing process.

More in particular, the method as disclosed herein provides that said method further comprises the step of regulating, on the basis of said measurement of said amount of optical absorption of the process gas, the delivery of said precursor to said process chamber by adjusting the volume flow rate of said carrier gas.

Another aspect of the present disclosure relates to a system for the manufacturing of semiconductors comprising at least a precursor vessel, a process chamber and a gas line between said precursor vessel and said process chamber, wherein said system further comprises a single-wavelength absorption-based detection system positioned on said gas line, adapted for measuring the amount of optical absorption of the process gas passing through said gas line, said system further comprising a controller communicatively coupled to said detection system and configured to determine the amount of solid precursor in said precursor vessel from the measurements of said detection system.

The single-wavelength absorption-based detection system as used herein is a system that measures the absorption of monochromatic light in the gas line connecting the precursor chamber with the process chamber. In some embodiments, it provides a time-averaged measurement of the amount of precursor in the gas line. The detection system may either be adapted for quasi-steady-state measurements and/or for transient measurements.

More in particular, the system as disclosed herein provides that said detection system comprises at least a monochromatic light source and a detector adapted for measuring the absorption of monochromatic light in said gas line. The light source, detector, and fiber optics of the detection system are matched to the absorption peak of the particular precursor used.

More in particular, the system according to the present disclosure provides that said system further comprises a flow meter for determining the volume flow rate of said process gas through said gas line. The use of a flow meter allows for a better assessment of the absorption based measurements and allows for a more efficient and secure monitoring of the remaining amount of solid precursor in the precursor chamber.

More in particular, the system as disclosed herein provides that said controller is further configured to determine the time remaining before the precursor vessel is depleted and/or requires refilling.

More in particular, the system according to the present disclosure provides that said controller is further configured to determine the amount of precursor delivered to said process chamber.

More in particular, the system as disclosed herein provides that said controller is configured to communicate the amount of precursor remaining in said precursor vessel and/or the mass flow rate of said precursor to said process chamber to a further system controller.

More in particular, the system according to the present disclosure provides that said controller or said system controller is configured to display the amount of precursor remaining in said precursor vessel and/or the mass flow rate of said precursor to said process chamber on a graphical user interface (GUI), wherein said controller or said system controller is further configured to generate an alarm message on said GUI in when said amount of precursor remaining in the vessel is below a pre-determined threshold value.

A "controller" may be coupled to various components of the processing system for controlling the operation thereof. The controller generally comprises a central processing unit (CPU), a memory, and support circuits for the CPU. The controller may control the processing system directly, or via computers (or controllers) associated with particular process chamber and/or the support system components. The controller may be one of any form of general-purpose computer processor that can be used in an industrial setting for controlling various chambers and sub-processors. The memory, or computer-readable medium of the CPU may be one or more of readily available memory such as random-access memory (RAM), NAND memory, read only memory (ROM), floppy disk, hard disk, flash, or any other form of digital storage, local or remote. The support circuits are coupled to the CPU for supporting the processor in a conventional manner. These circuits include cache, power supplies, clock circuits, input/output circuitry and subsystems, and the like. Inventive methods as described herein may be stored in the memory as software routine that may be executed or invoked to control the operation of the processing system in the manner described herein. The software routine may also be stored and/or executed by a second CPU (not shown) that is remotely located from the hardware being controlled by the CPU.

An exemplary system as described herein is shown in figure 2. Figure 2 illustrates a system (200) in accordance with yet additional exemplary embodiments of the disclosure. The system (200) can be used to perform a method as described herein and/or form a structure or device portion as described herein.

In the illustrated example, the system (200) includes one or more reaction chambers (202), a precursor gas source (204), a reactant gas source (206), a purge gas source (208), an exhaust (210), and a controller (212).

The reaction chamber (202) can include any suitable reaction chamber, such as an ALD or CVD reaction chamber.

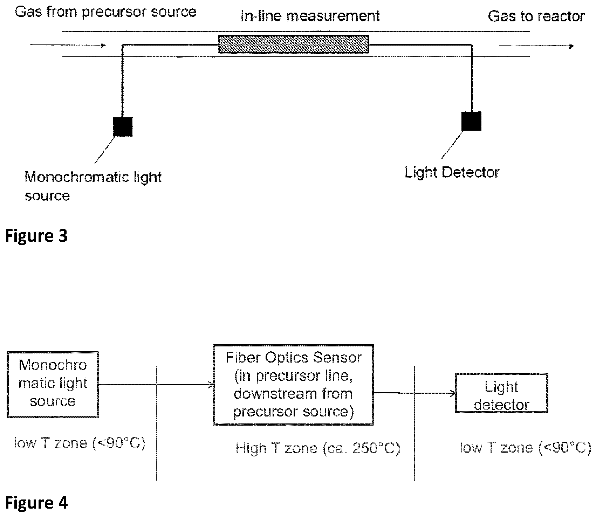

The precursor gas source (204) can include a vessel and one or more precursors as described herein-alone or mixed with one or more carrier (e.g., noble) gases. The reactant gas source (206) can include a vessel and one or more reactants as described herein-alone or mixed with one or more carrier gases. The purge gas source (208) can include one or more noble gases such as He, Ne, Ar, Kr, or Xe. Although illustrated with four gas sources (204)-(208), the system (200) can include any suitable number of gas sources. The gas sources (204)-(208) can be coupled to reaction chamber (202) via lines (214)-(218), which can each include flow controllers, valves, heaters, and the like. Suitably, at least one of the lines (214)-(218), such as the line (214) connecting the precursor source (204) to the reaction chamber (202), comprises an optical absorption sensing system for measuring optical absorption in a gas stream that flows through that line. Suitable absorption sensing systems are described elsewhere herein. Exemplary absorption gas sensing systems are described in figures 3 and 4.

The exhaust (210) can include one or more vacuum pumps.

The controller (212) includes electronic circuitry and software to selectively operate valves, manifolds, heaters, pumps and other components included in the system (200). Such circuitry and components operate to introduce precursors and purge gases from the respective sources (204)-(208). The controller (212) can control timing of gas pulse sequences, temperature of the substrate and/or reaction chamber, pressure within the reaction chamber, and various other operations to provide proper operation of the system (200). The controller (212) can include control software to electrically or pneumatically control valves to control flow of precursors, reactants and purge gases into and out of the reaction chamber (202). The controller (212) can include modules such as a software or hardware component, e.g., a FPGA or ASIC, which performs certain tasks. A module can advantageously be configured to reside on the addressable storage medium of the control system and be configured to execute one or more processes.

Other configurations of the system (200) are possible, including different numbers and kinds of precursor and reactant sources and purge gas sources. Further, it will be appreciated that there are many arrangements of valves, conduits, precursor sources, and purge gas sources that may be used to accomplish the goal of selectively feeding gases into the reaction chamber (202). Further, as a schematic representation of a system, many components have been omitted for simplicity of illustration, and such components may include, for example, various valves, manifolds, purifiers, heaters, containers, vents, and/or bypasses.

During operation of the reactor system (200), substrates, such as semiconductor wafers (not illustrated), are transferred from, e.g., a substrate handling system to the reaction chamber (202). Once substrate(s) are transferred to the reaction chamber (202), one or more gases from the gas sources (204)-(208), such as precursors, reactants, carrier gases, and/or purge gases, are introduced into the reaction chamber (202).

Figure 3 illustrates an absorption gas sensing system in which the in line measurement occurs in the gas line between the precursor vessel and the process reactor. The monochromatic light source and photodetector or light detector are positioned outside the gas line, in low temperature environment preferably at a temperature below 90°C. For transient measurements of the amount of optical absorption of the process gas the light is brought to the gas line via fiber optics. The light travels freely through the gas line for a pre-determined distance during which the precursor, carrier gas and/or analyte concentration in the gas line influences the optical absorption of the light passing through the gas line, hence allowing the measurement of the concentration of the precursor, carrier gas or analyte in the process gas. From these measurements the amount of precursor in the precursor vessel can be determined.

Figure 4 illustrates, similar to figure 3 an absorption gas sensing system in which the in line measurement occurs in the gas line between the precursor vessel and the process reactor. The monochromatic light source and photodetector or light detector are positioned outside the gas line, in low temperature environment preferably at a temperature below 90°C. For quasi steady state measurements a fiber optics sensor such as a Bragg element is positioned in the gas line. The monochromatic light source and a light detector positioned outside the gas line in low temperature environment, preferably at a temperature below 90°C, the light source and a light detector being connected to the fiber optics sensor through fiber optics, in particular fiber optics comprising one or more beam splitters. This quasi steady state measurement system allows for the sensing of the precursor, carrier gas or analyte concentration in the process gas. The precursor, carrier gas or analyte in the process gas changes the refractive index and extinction coefficient of the gas phase. Accordingly, changes in the process gas changes occur in at least one of the amount of reflected light and transmitted light by the fiber optic sensor and this is indicative for the concentration of the precursor, carrier gas or analyte in the process gas. From these measurements the amount of precursor in the precursor vessel can be determined.

## Claims

1. A method for determining the amount of solid precursor in a precursor vessel for a semiconductor manufacturing process, wherein said solid precursor is provided from said precursor vessel to a process chamber by:
• flowing a carrier gas through said precursor vessel, thereby generating a process gas comprising said carrier gas and vaporized solid precursor, and
• providing said process gas to said process chamber where said precursor is reacted with a substrate,
the method comprising the step of:
• measuring an amount of optical absorption of that process gas through monochromatic measurements in said process gas, and
• determining, based on the measurement of said optical absorption of the process gas, said amount of precursor in said precursor vessel.

2. The method according to claim 1, wherein said measurement of said optical absorption of the process gas is an in-line measurement in the gas line fluidically connecting said precursor vessel to said process chamber.

3. The method according to claim 1 or 2, wherein said measurement of said optical absorption of the process gas comprises a quasi-steady-state measurement.

4. The method according to any one of claims 1 to 3, wherein said measurement of said optical absorption of the process gas comprises a transient measurement.

5. The method according to any of claims 1 to 4, wherein said method further comprises the step of determining, based on said measurement of said optical absorption of the process gas, the time remaining before said precursor vessel is depleted and/or requires refilling.

6. The method according to any of claims 1 to 5, wherein determining the amount of precursor in said precursor vessel comprises determining, based on said measurement of said optical absorption of the process gas, the remaining amount of precursor in said precursor vessel.

7. The method according to any of claims 1 to 6, wherein said method further comprises the step of determining, based on said measurement of said optical absorption of the process gas , the amount of precursor delivered to said process chamber.

8. The method according to any of claims 1 to 7, wherein said method further comprises the step of regulating, on the basis of said measurement of said optical absorption of the process gas, the delivery of said precursor to said process chamber by adjusting the volume flow rate of said carrier gas.

9. The method according to any of claims 1 to 8, wherein said precursor comprises a metal.

10. The method according to claim 9, wherein said metal is selected from an alkaline metal, an alkaline earth metal, a transition metal, a transition metal, and a rare earth metal.

11. The method according to any of claims 1 to 10, wherein the precursor comprises one or more ligands, the one or more ligands being selected from H, halogens, alkyls, alkenyls, alkynes, carbonyls, dienyls, beta-diketonates, substituted or unsubstituted cyclodienyls, and substituted or unsubstituted aryls.

12. The method according to any of claims 1 to 11, wherein the precursor is homoleptic.

13. The method according to any of claims 1 to 11, wherein the precursor is heteroleptic.

14. The method according to any of claims 1 to 13, wherein the precursor comprises a metal-carbon bond.

15. The method according to any of claims 1 to 14, wherein the precursor comprises a pi complex.

16. A system for the manufacturing of semiconductors comprising at least a precursor vessel, a process chamber and a gas line between said precursor vessel and said process chamber, wherein said system further comprises a single-wavelength absorption-based detection system positioned on said gas line, adapted for measuring an optical absorption of a process gas passing through said gas line, said system further comprising a controller communicatively coupled to said detection system and configured to determine the amount of solid precursor in said precursor vessel from the measurements of said detection system.

17. The system according to claim 16, wherein said detection system comprises at least a monochromatic light source and a detector adapted for measuring the absorption of monochromatic light in said gas line.

18. The system according to claim 16 or 17, wherein said system further comprises a flow meter for determining the volume flow rate of said process gas through said gas line.

19. The system according to any of claims 16 to 18, wherein said controller is further configured to determine the time remaining before the precursor vessel is depleted and/or requires refilling.

20. The system according to any of claims 16 to 19, wherein
- said controller is further configured to determine the amount of precursor delivered to said process chamber;
- said controller is configured to communicate the amount of precursor remaining in said precursor vessel and/or the mass flow rate of said precursor to said process chamber to a further system controller; and,
- said controller or said system controller is configured to display the amount of precursor remaining in said precursor vessel and/or the mass flow rate of said precursor to said process chamber on a graphical user interface (GUI), wherein said controller or said system controller is further configured to generate an alarm message on said GUI in when said amount of precursor remaining in the vessel is below a pre-determined threshold value.
